(19) Europäisches Patentamt / European Patent Office / Office européen des brevets

(11) **EP 2 259 329 A1**

(12) **EUROPEAN PATENT APPLICATION**

(43) Date of publication:
**08.12.2010 Bulletin 2010/49**

(51) Int Cl.:
*H01L 31/0224* (2006.01)    *H01L 51/52* (2006.01)
*H01L 51/44* (2006.01)    *H01L 33/36* (2010.01)

(21) Application number: **09382079.3**

(22) Date of filing: **26.05.2009**

(84) Designated Contracting States:
**AT BE BG CH CY CZ DE DK EE ES FI FR GB GR HR HU IE IS IT LI LT LU LV MC MK MT NL NO PL PT RO SE SI SK TR**

(71) Applicants:
- **Institut de Ciències Fotòniques, Fundació Privada**
  **08860 Castelldefels, Barcelona (ES)**
- **Institució Catalana de Recerca i Estudis Avançats**
  **08010 Barcelona (ES)**

(72) Inventors:
- **Pruneri, Valerio**
  **08860, Castelldefels (Barcelona) (ES)**
- **Ghosh, Dhriti, Sundar**
  **08860, CASTELLDEFELS (Barcelona) (ES)**

(74) Representative: **Carpintero Lopez, Francisco et al**
  **Herrero & Asociados, S.L.**
  **Alcalá 35**
  **28014 Madrid (ES)**

(54) **Metal transparent conductors with low sheet resistance**

(57) The present invention relates to a transparent electrode comprising an ultra thin metal conductor (2) with a thickness between 1nm and 10nm and a metal grid (3) in contact with the ultra thin metal conductor (2), the metal grid comprising openings. The invention relates also to a method for its manufacture. It can be applied in, for example, optoelectronic devices. Thanks to the metal grid, the sheet resistance of the electrode can be lowered without compromising the transparency of the electrode.

Section A-A

Fig. 3

EP 2 259 329 A1

**Description**

**TECHNICAL FIELD**

The present invention relates to optically transparent and electrically conductive metal electrodes for, for example, optoelectronic applications.

**BACKGROUND OF THE INVENTION**

Transparent electrodes (TEs), i.e. films which can conduct electricity and at the same time transmit light, are of crucial importance for many optical devices, such as photovoltaic cells, organic light emitting diodes, integrated electro-optic modulators, laser displays, photo-detectors, etc. From an application point of view, besides large optical transparency in the wavelength range of interest and adequate electrical conductivity, transparent electrodes should possess other key features, such as easy processing (e.g. possibility for large scale deposition), compatibility with other materials that form the same device (e.g. active layers), stability against temperature, mechanical and chemical stress, and low cost.

So far, transparent electrodes have been mainly fabricated using Transparent Conductive Oxides (TCOs), i.e. wide band gap semiconductors with heavy metal doping. Among them, Indium Tin Oxide (ITO) is the most widely used. Despite possessing large electrical conductivity and optical transparency in the visible region, TCOs present several drawbacks such as the requirement of high temperature (several hundreds of $\underline{o}$C) post deposition treatments to improve mainly their electrical properties, their strong electrical and optical dependence on the doping control and their multicomponent structure that can lead to incompatibilities with some active materials. Often, such as in the case of ITO, they are made of elements (In) which are not easily available in large quantities and thus expensive.

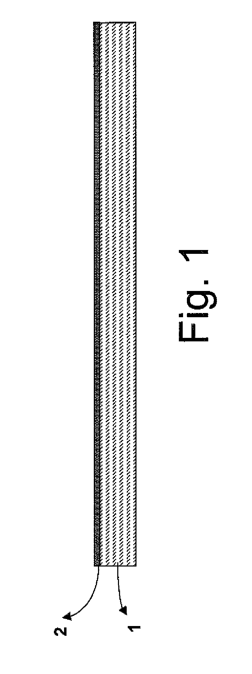

Another type of TE which has been more recently investigated is based on ultrathin metal film (UTMF), i.e. film with a thickness in 2 to 20 nm range (Fig. 1). For instance R. B. Pode, et. al. ("Transparent conducting metal electrode for top emission organic light-emitting devices: Ca-Ag double layer", Appl. Phys. Lett. 84,4614, 2004) propose a composite ultra thin metal electrode made of calcium and silver. Platinum polycrystalline metal films with a (111) texture have also been considered as UTMFs (Sabrina Conoci, Salvatore Petralia, Paolo Samorì, Françisco M. Raymo, Santo Di Bella, and Salvatore Sortino" Optically Transparent, Ultrathin Pt Films as Versatile Metal Substrates for Molecular Optoelectronics", Advanced Functional Materials Volume 16, Issue 11, Pages 1425-1432). Single component Cr, Ni, Ti and Al based UTMFs have been investigated in several publications (S. Giurgola, P. Vergani, V. Pruneri "Ultra thin metal films as an alternative to TCOs for optoelectronic applications", Nuovo Cimento B 121, 887-897, 2006; S. Giurgola, A. Rodríguez, L. Martínez, P. Vergani, F. Lucchi, S. Benchabane, V. Pruneri, "Ultra thin nickel transparent electrodes" J. Mater. Sci: Mater. Electron. 20, S181-S184, 2009). Single-component UTMFs can overcome the high cost of raw materials such as indium (In), and can be grown using a simple single process technique, i.e. sputtering, thus becoming a straightforward solution to be integrated into typical industrial process flows. Contrary to TCOs, they possess high compatibility with nearly all organic and semiconductor materials (e.g. active medium) and related device fabrication steps.

The electrical resistivity ($\rho$) in $\Omega \cdot m$ of UTMFs can be lower than that of TCOs. However, if one wants to achieve high optical transmission, the thickness (t) of the UTMFs is limited to several nm while that of TCOs can easily reach 100 nm. This implies that the sheet resistance (Rs) in $\Omega/$ , which is given by $\Box$ /t, of UTMFs is relatively high compared to TCOs. For example Rs of 2 and 10 nm Ni films are in the range of 1000 and 50 $\Omega/$ , respectively, while Rs of 100 nm ITO film is in the 10 to 20 $\Omega/$ range. The optical transmission of such Ni films is comparable to 100 nm ITO in the visible range while is larger in the UV (175-400nm) and mid-IR (2.5-25$\mu$m) ranges (D.S. Ghosh, L. Martínez, S. Giurgola, P. Vergani, V. Pruneri, "Widely transparent electrodes based on ultrathin metals" Optics Letters 34, 325-327,2009). If the thickness of Ni is further increased lower Rs values can be achieved at the expense of the optical transmission. In fact 40 nm films can achieve Rs values of about 5 $\Omega/$ but become opaque. The larger the Rs value of a TE the higher the ohmic (resistive) loss in the devices using the TE, thus the larger the power (energy) loss and the probability that the device fails due to thermal loading in the TE area. Ohmic losses become critical for high current devices (e.g. laser sources and solar cells) while are less critical for low current devices (e.g. integrated modulators and displays which rely on capacitive charging).

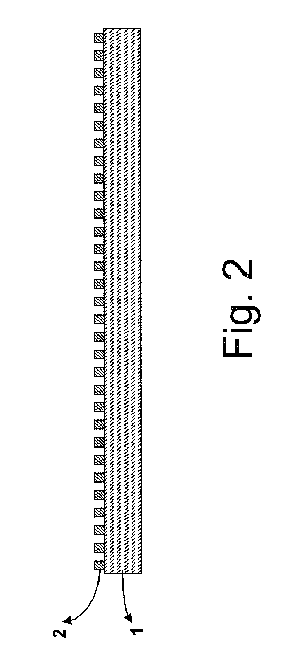

Patterning of metals has been recently proposed to achieve an efficient TE (Myung-Gyu Kang and L. Jay Guo, "Nanoimprinted semitransparent metal electrodes and their application in organic light emitting diodes" Adv. Mater. 19, 1391-1396, 2007). The semitransparent metal electrodes are in the form of a nm-scale periodically perforated dense metal on the substrate (Fig.2). By changing the aperture ratio and the thickness of the metal the optical transparency and the sheet resistance can be tuned. In fact it is shown that values comparable to ITO can be achieved at the same time for both parameters. The linewidth (i.e. the width of the regions where the metal is present) has to be sub-wavelength, to provide sufficient transparency and to minimize scattering. In addition the period of the structure has to be sub-micrometer to ensure the uniformity of the current onto the substrate surface (e.g. uniform injection or extraction of currents into or from an active layer). The latter drawback, i.e. the need of very small structural features with sub-micrometer periods, is due to the fact that the electrode is missing on the majority of the area and the ohmic loss due to conduction has to be kept small. The structure being in the nanometer to micron range, the proposed approach requires demanding and expensive conventional lithographic techniques for patterning. To make it less expensive nonconventional lithographic techniques, such as nano-imprinting, have been used (WO 2006/132672 A2). Such techniques have however several drawbacks, including likelihood of missing metal lines and are more expensive than conventional techniques for patterning on a larger scale (micron to mm range), including UV lithography, screen printing and shadow masking during deposition.

## SUMMARY OF THE INVENTION

Accordingly, it is aim of the present invention to devise a way to decrease the Rs value of UTMF based TE without significantly reducing the corresponding optical transmission. Therefore, the invention provides a transparent electrode comprising an ultra thin metal conductor with a thickness between 1 nm and 10nm, and further comprising a metal grid in contact with the ultra thin metal conductor, the metal grid comprising openings.

The ultra thin metal conductor has preferably a thickness of 2nm to 8nm. Both the ultra thin metal and the grid can comprise Ni, Cr, Ti, Al, Cu, Ag , Au or a mixture thereof, being of the same or a different material. Preferably, the fill factor of the metal grid is not more than a 5% and the ultra thin metal conductor is continuous. The metal grid can have a thickness in the order of $10^{-9}$ m to $10^{-5}$ m and a linewidth between $5 \times 10^{-6}$ m and $5 \times 10^{-5}$ m. Optionally, the grid has a square or rectangular like pattern.

The method of manufacturing the transparent electrode metal film comprises the steps of:

a. depositing a continuous ultra thin metal film (2) on a substrate (1) with a thickness between 1 nm and 10nm
b. depositing a metal grid comprising openings (3) on said continuous ultra thin metal film.

Step a. is advantageously performed by sputtering deposition. Step b. can be performed by UV lithography, soft lithography, screen printing or by a shadow mask. The substrate comprises preferably silica, borosilicate, silicon, lithium niobate, or polyethylene terephthalate. The starting roughness of the substrate should be below the thickness of the film to assure its continuity. The metal conductor can be oxidized before or after the deposition of the grid.

## BRIEF DESCRIPTION OF THE FIGURES

To complete the description and in order to provide for a better understanding of the invention, a set of drawings is provided. Said drawings form an integral part of the description and illustrate a preferred embodiment of the invention, which should not be interpreted as restricting the scope of the invention, but just as an example of how the invention can be embodied. The drawings comprise the following figures:

Fig. 1 shows the typical layout of a TE based on UTMF on a substrate according to the prior art

Fig. 2 shows a nanoimprinted metal grid according to the prior art.

Fig. 3 shows a TE structure according to the invention composed of a uniform UTMF with a top metal grid.

Fig. 4 shows the total sheet resistance (UTMF with top grid of structure in fig. 3) as a function of grid linewidth (w) for different thickness.

Fig. 5 shows the total sheet resistance (UTMF with top grid of structure in fig. 4) as a function of grid linewidth (w) for different gaps, G=Λ-w, where Λ is the period.

Fig. 6 shows the overall optical transmission with respect to the UTMF transmission (i.e. transmission decrease due to the grid) as a function of grid linewidth (w) for different gaps G=Λ-w. In practice for Ni, for example, the grid becomes opaque at $t_G \geq 40$nm.

## DESCRIPTION OF THE INVENTION

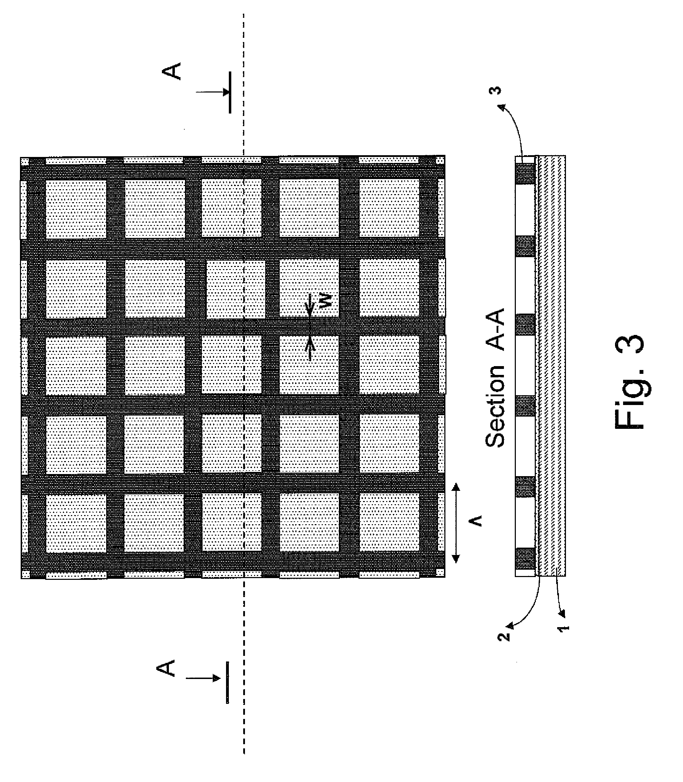

One aspect of the invention relies on the use of a uniform, continuous UTMF with a larger thickness metal grid on top of it (Fig. 3). Depending on the application such grid can be either on a nm to micron scale (e.g. in the case of LEDs where the scattering due to metal lines are to be avoided to preserve the output optical beam quality) or micron to hundreds of microns scale (e.g. in the case of solar cells where preserving the quality of the incoming optical beam is not essential). The period and linewidth of the grid depend also on the thickness of the underneath UTMF and the local currents involved. In general the lower the UTMF thickness and the larger the current densities, the smaller the uncovered regions by the grid. The thickness of the metal grid ($t_G$) is related to the fill factor (ratio between linewidth w and period $\Lambda$) and the thickness of the underneath UTMF ($t_{UTMF}$). Note that the $\rho$ values for the metal grid structure ($\rho_G$) are typically significantly lower than those of the UTMF layer ($\rho_{UTMF}$) because the larger the thickness of the metal layer (t) the lower the $\rho$ value. This makes the sheet resistance Rs (=$\rho$/t) of the grid with respect to that of the UTMF underneath even lower than one would expect by simply scaling the thickness. In practical cases the sheet resistance of the underneath UTMF becomes negligible on a scale larger than the period of the grid, however still important locally (within the period length of the grid) to collect or inject charges from and into regions where the metal grid lines are absent.

One aspect of the present invention refers to a method to produce a metal based TE that comprises the steps of:

a) depositing of a continuous UTMF film on a substrate;
b) depositing of a metal grid on the aforesaid UTMF; to obtain a metal film which has a significantly reduced electrical sheet resistance and only slightly reduced optical transmission with respect to the initially deposited UTMF.

The overall sheet resistance of the film structure reported in fig. 3 (square mesh) can be written as

$$R_{S,TOT} = \frac{\dfrac{\rho_G}{t_G}\dfrac{\Lambda}{w}\left(\dfrac{\rho_G}{t_G}\dfrac{w}{\Lambda - w} + \dfrac{\rho_{UTMF}}{t_{UTMF}}\right)}{\dfrac{\rho_G}{t_G}\dfrac{\Lambda}{w} + \dfrac{\rho_G}{t_G}\dfrac{w}{\Lambda - w} + \dfrac{\rho_{UTMF}}{t_{UTMF}}}$$

where all the parameters have already been defined above. In fact with good approximation the sheet resistance on a scale larger than the period of the mesh can be approximated by ($\rho_G/t_G$)($\Lambda$/w), i.e. the sheet resistance of the top grid, being the sheet resistance of the UTMF much larger. However as it was said above the sheet resistance locally, within the inner square of linear dimension $\Lambda$-w, is given by the UTMF layer.

The overall optical transmission (T) is given by the following expression:

$$T = T_{UTMF} \bullet \left(1 - \frac{w}{\Lambda}\right)^2$$

Where $T_{UTMF}$ is the transmission of the initially deposited UTMF. Note that for simplicity we have assumed that the thickness of the metal grid is large enough to make it opaque.

The above expressions hold for a square like mesh depicted in fig. 3, however the design guidelines illustrated for this pattern geometry apply also to any type of grids with continuous lines, e.g. rectangular or stripes.

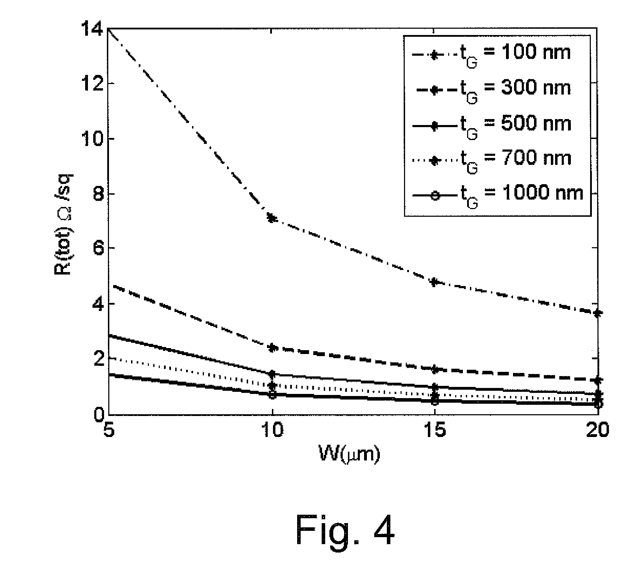

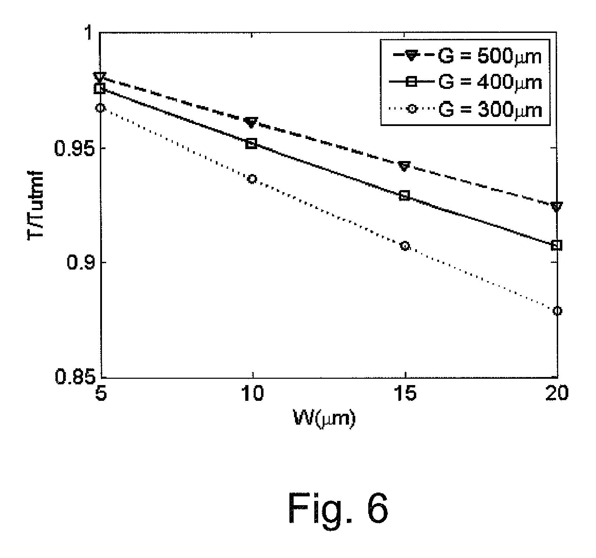

Fig. 4, 5 and 6 show the dependence of overall sheet resistance and optical transmission with respect to UTMF and grid parameters. The following parameters were assumed: $\Lambda$-w = 500 $\mu$m ; $t_{UTMF}$ = 2 nm ; $\rho_G$ = 14 * 10 $^{-9}$ $\Omega$m ; $\rho_{UTMF}$ = 191.2 * 10 $^{-8}$ $\Omega$m; $t_G$ = 500 nm. The $\rho$ values are experimental values for Ni, in particular it was experimentally assessed that in practice the above $\rho_G$ value holds for $t_G \geq 40$nm. Above this $t_G$, the grid becomes opaque. However the design principle of this invention applies to whatever metals, including structures where the UTMF and the grid are of different metals. From the figures it is clear that there exists a trade-off between sheet resistance and optical transmission. One can also straightforwardly appreciate that an appropriate Ni based grid allows achieving overall sheet resistance values well below 10 $\Omega$/ without significant reduction in optical transmission, especially by increasing the grid thickness.

The above expressions with examples given in the micron range for the linewidth and period of the grid are still valid in the nm and hundreds of micrometers range and, as already said, can be adapted to any metal, combination of metals and grid geometry. Thus the design guidelines provided in this patent application can be generalised depending on device requirements (e.g. nm to micron or micron to hundreds of micron grid), fabrication constraints, etc. In particular the UTMF layer might be a different material than that of the metal grid. The former layer has to be transparent, sufficiently conductive within the uncovered regions by the grid, compatible with the substrate material (e.g. an appropriate work function in the case of active device) while the latter has mainly to be electrically efficient. Examples of metals for the UTMF and grid layers include Ni, Cr, Ti, Al, Cu, Ag and Au. A preliminary experimental assessment has been carried out using Ni UTMF and Ni grid. The following table summarises the obtained results.

|  | $\rho(\mu\Omega.cm)$ | $R_{s, TOT}$ $(\Omega/)$ | Optical transmission including substrate (%) |
|---|---|---|---|
| Only Ni UTMF with $t_{UTMF}$=2 mn | 191.2 | 955 | 74.5 |
| Ni UTMF above + Ni grid with w=5$\mu$m, G=500$\mu$m, $t_G$=40nm | - | 350 | 72 |
| Ni UTMF above + Ni grid with w=10$\mu$m, G=500$\mu$m, $t_G$=40nm | - | 165 | 70.3 |

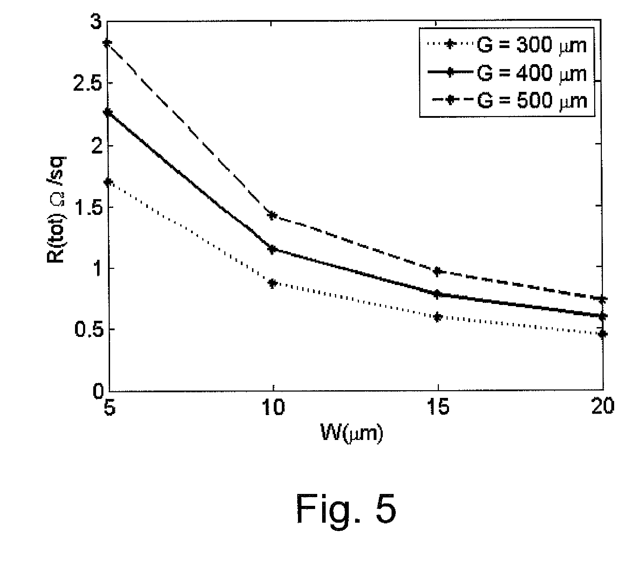

The effect of reduction of sheet resistance and nearly unchanged optical transmission due to the grid is clearly evident, so is the dependence of both parameters with respect to linewidth of the grid. The experimental values of grid thickness were limited to 40 nm. It is however evident from fig. 5 that larger grid thicknesses can be achieved to further reduce the overall sheet resistance, especially for grid structures with period and linewidth in the micron to hundreds of micron range.

Step a) of the process of the invention may be carried out according to any conventional method. In a particular embodiment, step a) is carried out by sputtering deposition under vacuum. The starting surface roughness of the substrate should preferably be below the thickness of the film; otherwise said film could be discontinuous and thus non-conductive.

Generally the ultra thin metal film deposited in step a) presents a thickness comprised between 1 and 10 nm.

Any metal may be used as the thin metal film as long as it maintains sufficient uniformity over the whole deposited area, especially for small thicknesses. In a particular embodiment Ni is used for both the UTMF and grid layers.

The thin layer is deposited on to a substrate said substrate being a dielectric substrate, such as glass, a semiconductor, an inorganic crystal or plastic material. Examples of them are silica ($SiO_2$), borosilicate (BK7), silicon (Si), lithium niobate ($LiNbO_3$), or polyethylene terephthalate (PRT), among others, suitable for putting the invention into practice. Note that substrate refers to the material over which the UTMF is deposited. It can be part of a device structure, e.g. an active semiconductor or organic layer.

Step b) of the method of the invention can be carried out in several ways, depending on the metal and dimensions of the structure. The grid patterning may rely , e.g., on UV lithography, soft lithography (nano-imprinting), screen printing or shadow mask, depending on the geometrical constraints, while the deposition on techniques similar to those used for the UTMF layer or others for thicker layers, e.g. evaporation or electroplating. All the techniques are known to a person skilled in the art.

The sheet resistance of the initial UTMF should be in the 50 to 1000 $\Omega/$ range, depending on the application and subsequent grid geometry while the decrease in optical transmission with respect to the substrate should be lower than 30% and preferably less than 10%. As a result of the subsequent grid fabrication the resulting overall sheet resistance should be in the range of 1 to 100 $\Omega/$ while the optical transmission decrease should be in the range of 1 to 10%.

Optionally the UTMF can be oxidised to increase its stability before or after the grid deposition.

In view of the above it can be seen that the method of the present invention presents the important advantage of providing metal based TE with low sheet resistance which find many applications due to their simple and low cost method of fabrication and their intrinsic technical characteristics. In this sense it is known that in devices such as photovoltaic cells, organic light emitting diodes, displays, integrated electro-optic modulators, lasers and photo-detectors, transparent conductive electrodes are key elements, and are combined with other materials.

The foregoing is illustrative of the present invention. This invention however is not limited to the following precise embodiment described herein, but encompasses all equivalent modifications within the scope of the claims which follow.

## DESCRIPTION OF A PREFERRED EMBODIMENT

A 2 nm ultrathin Ni film was deposited on a double side polished UV fused silica substrate using Ajaint Orion 3 DC sputtering system. The sputtering was performed at room temperature in a pure argon atmosphere of 0.27 Pa (about 2 mTorr) and 100 W DC power. Prior to the deposition the substrate was cleaned with oxygen plasma with oxygen base pressure of 1.1 Pa (about 8 mTorr) and 40 W RF power for 15 minutes.

A positive photoresist is then spincoated on the film with 4000 rounds per minute and dwell time of 30 seconds. This recipe produces a photoresist thin film of about 1.2 - 1.3 μm. In fact, the thickness of the photoresist determines the maximum thickness of the metal grid to be deposited later in the process. The sample is then baked at 90 C for 5 minutes to evaporate the solvent in the photoresist. Thereafter, the sample is exposed to UV light for 15 seconds using Quintal Q4000 mask aligner with a hard mask of desired grid pattern placed on top of the sample. The exposed sample is then developed for about 40 seconds which removes the photoresist in the regions of the sample where the UV light is not blocked by the hard mask, thus making openings in the sample to deposit the thick metal grid.

The sample is again loaded in the sputtering chamber and a thick metal is deposited using the same aforementioned conditions. After depositing the thick metal the sample is dipped in acetone and placed in an ultrasonic bath till the remaining photoresist is lifted off.

The sheet resistance of the obtained structure (UTMF together with grid) as well as the initial UTMF film is measured by Cascade Microtech 44/7S Four point Probe and Keithley 2001 multimeter. For the transmission spectra, a Perkin Elmer Lambda 950 spectrophotometer was used.

In this text, the term "comprises" and its derivations (such as "comprising", etc.) should not be understood in an excluding sense, that is, these terms should not be interpreted as excluding the possibility that what is described and defined may include further elements, steps, etc.

On the other hand, the invention is obviously not limited to the specific embodiment(s) described herein, but also encompasses any variations that may be considered by any person skilled in the art (for example, as regards the choice of materials, dimensions, components, configuration, etc.), within the general scope of the invention as defined in the claims.

**Claims**

1. Transparent electrode comprising an ultra thin metal conductor (2) with a thickness between 1 nm and 10nm **characterized in that** it further comprises a metal grid in contact with the ultra thin metal conductor (3), the metal grid comprising openings.

2. Transparent electrode according to claim 1 wherein the ultra thin metal conductor has a thickness of 2nm to 8nm.

3. Transparent electrode according to any of the preceding claims wherein the ultra thin metal conductor comprises Ni, Cr, Ti, Al, Cu, Ag , Au or a mixture thereof.

4. Transparent electrode according to any of the preceding claims wherein the metal grid comprises Ni, Cr, Ti, Al, Cu, Ag , Au or a mixture thereof.

5. Transparent electrode according to any of the preceding claims, wherein the fill factor of the metal grid is not more than a 5%.

6. Transparent electrode according to any of the preceding claims wherein the ultra thin metal conductor is continuous.

7. Transparent electrode according to any of the preceding claims wherein the metal grid has a thickness in the order of $10^{-9}$ m to $10^{-5}$ m.

8. Transparent electrode according to any of the preceding claims wherein the metal grid has a linewidth between $5 \times 10^{-6}$ m and $5 \times 10^{-5}$ m.

9. Transparent electrode according to any of the previous claims wherein the metal grid has a square or rectangular like pattern.

10. Method of manufacturing a transparent electrode comprising the steps:

    a. depositing a continuous ultra thin metal film (2) on a substrate (1) with a thickness between 1 nm and 10nm
    b. depositing a metal grid comprising openings (3) on said continuous ultra thin metal film

11. Method according to claim 10 wherein step a. is performed by sputtering deposition.

12. Method according to any of the claims 10-11 wherein step b. is performed by UV lithography, soft lithography, screen printing or by a shadow mask.

13. Method according to any of the claims 10-12 wherein the substrate comprises silica, borosilicate, silicon, lithium niobate, or polyethylene terephthalate.

14. Method according to any of claims 10-13 wherein the starting roughness of the substrate is below the thickness of the film.

15. Method according to any of claims 10-14 wherein the ultra thin metal conductor is oxidized before or after the deposition of the grid.

EP 2 259 329 A1

## Fig. 1

Fig. 2

Section A-A

Fig. 3

Fig. 4

EP 2 259 329 A1

Fig. 5

Fig. 6

EP 2 259 329 A1

Europäisches
Patentamt
European
Patent Office
Office européen
des brevets

## EUROPEAN SEARCH REPORT

Application Number

EP 09 38 2079

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP 2006 134827 A (NIPPON OIL CORP) 25 May 2006 (2006-05-25) * abstract * * paragraphs [0003] - [0010] * * paragraphs [0016], [0017] * * figures 1,2 * | 1-14 | INV. H01L31/0224 H01L51/52 H01L51/44 H01L33/36 |
| Y | | 15 | |
| Y | GOSH D S ET AL: "Widely transparent electrodes based on ultrathin metals" OPTICS LETTERS, OSA, OPTICAL SOCIETY OF AMERICA, WASHINGTON, DC, US, vol. 34, no. 3, 1 February 2009 (2009-02-01), pages 325-327, XP001521884 ISSN: 0146-9592 * page 325, column 1, last paragraph - column 2, last paragraph * * page 327, columns 1,2 * | 15 | |
| A | | 2,3,13, 14 | **TECHNICAL FIELDS SEARCHED (IPC)** |
| X | US 4 345 107 A (FULOP GABOR F ET AL) 17 August 1982 (1982-08-17) * column 4, line 28 - column 5, line 2 * * column 8, lines 3-34 * * column 10, line 63 - column 11, line 2 * * figure * | 1-14 | H01L |
| A | | 15 | |
| X | EP 1 453 117 A (SCHOTT GLAS [DE]; ZEISS CARL STIFTUNGTRADING AS [DE] SCHOTT AG [DE]) 1 September 2004 (2004-09-01) * paragraphs [0058] - [0063] * * paragraphs [0092] - [0098] * * figures 7A-7D * | 1-14 | |
| A | | 15 | |

-/--

The present search report has been drawn up for all claims

| Place of search | Date of completion of the search | Examiner |
|---|---|---|
| Berlin | 4 November 2009 | Weis, Thomas |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

Europäisches
Patentamt

European
Patent Office

Office européen
des brevets

**EUROPEAN SEARCH REPORT**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 2 031 660 A (BOEING CO [US]) 4 March 2009 (2009-03-04) * paragraph [0004] * * paragraphs [0014] - [0021] * * figures 2,3 * ----- | 1-9 | |

TECHNICAL FIELDS
SEARCHED      (IPC)

The present search report has been drawn up for all claims

| Place of search | Date of completion of the search | Examiner |
|---|---|---|
| Berlin | 4 November 2009 | Weis, Thomas |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

# EP 2 259 329 A1

## ANNEX TO THE EUROPEAN SEARCH REPORT
## ON EUROPEAN PATENT APPLICATION NO.

EP 09 38 2079

This annex lists the patent family members relating to the patent documents cited in the above-mentioned European search report.
The members are as contained in the European Patent Office EDP file on
The European Patent Office is in no way liable for these particulars which are merely given for the purpose of information.

04-11-2009

| Patent document cited in search report | | Publication date | Patent family member(s) | | Publication date |
|---|---|---|---|---|---|
| JP 2006134827 | A | 25-05-2006 | NONE | | |
| US 4345107 | A | 17-08-1982 | NONE | | |
| EP 1453117 | A | 01-09-2004 | CN | 1525583 A | 01-09-2004 |
| | | | DE | 10308515 A1 | 16-09-2004 |
| | | | EP | 1597781 A2 | 23-11-2005 |
| | | | WO | 2004076230 A2 | 10-09-2004 |
| | | | US | 2004164674 A1 | 26-08-2004 |
| EP 2031660 | A | 04-03-2009 | CN | 101378088 A | 04-03-2009 |
| | | | JP | 2009060106 A | 19-03-2009 |
| | | | US | 2009056799 A1 | 05-03-2009 |

EPO FORM P0459

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 2006132672 A2

### Non-patent literature cited in the description

- **R. B. Pode.** Transparent conducting metal electrode for top emission organic light-emitting devices: Ca-Ag double layer. *Appl. Phys. Lett.,* 2004, vol. 84, 4614
- **Sabrina Conoci ; Salvatore Petralia ; Paolo Samorì ; Françisco M. Raymo ; Santo Di Bella ; Salvatore Sortino.** Optically Transparent, Ultrathin Pt Films as Versatile Metal Substrates for Molecular Optoelectronics. *Advanced Functional Materials,* vol. 16 (11), 1425-1432
- **S. Giurgola ; P. Vergani ; V. Pruneri.** Ultra thin metal films as an alternative to TCOs for optoelectronic applications. *Nuovo Cimento,* 2006, vol. 121, 887-897
- **S. Giurgola ; A. Rodríguez ; L. Martínez ; P. Vergani ; F. Lucchi ; S. Benchabane ; V. Pruneri.** Ultra thin nickel transparent electrodes. *J. Mater. Sci: Mater. Electron.,* 2009, vol. 20, S181-S184
- **D.S. Ghosh ; L. Martínez ; S. Giurgola ; P. Vergani ; V. Pruneri.** Widely transparent electrodes based on ultrathin metals. *Optics Letters,* 2009, vol. 34, 325-327
- **Myung-Gyu Kang ; L. Jay Guo.** Nanoimprinted semitransparent metal electrodes and their application in organic light emitting diodes. *Adv. Mater.,* 2007, vol. 19, 1391-1396